(19) Europäisches Patentamt
European Patent Office
Office européen des brevets

(11) **EP 2 169 412 A1**

(12) **EUROPEAN PATENT APPLICATION**

(43) Date of publication:
**31.03.2010 Bulletin 2010/13**

(51) Int Cl.:
*G01R 19/32* (2006.01)      *G01R 1/20* (2006.01)

(21) Application number: **08165094.7**

(22) Date of filing: **25.09.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Ilumab AB
449 44 NOL (SE)**

(72) Inventor: **Hellström, Jerker
449 44, NOL (SE)**

(74) Representative: **Edlund, Fabian
Awapatent AB
P.O. Box 11394
404 28 Göteborg (SE)**

(54) **Electrical current measurement arrangement**

(57)   An electrical current measurement arrangement (3) for a varying inductive load (2), which arrangement (3) comprises at least one shunt resistor (10), which shunt resistor (10) is represented by a plurality of conductive strips (23) connected in parallel, each strip (23) having a first predetermined width ($W_1$); and at least one compensation resistor (11), which compensation resistor (11) is represented by a compensation conductor (24) having a second predetermined width ($W_2$); wherein the shunt and compensation resistors (10, 11) are electrically separated, thermally connected, and derived from the same manufacturing process such that a compensation conductor thickness (T) of the compensation conductor (24) is equal to a strip thickness (T) of the strips (23).

Additionally, a method for manufacturing such an arrangement (3) is provided.

The compensation resistor (11) is hence utilized as a reference to improve the reliability of the measuring process (502-520), and a compensation reflecting circumstances affecting the compensation resistor (11) may be utilized to compensate the shunt resistor (10) accordingly.

Fig. 2

EP 2 169 412 A1

**Description**

Technical Field of the Invention

The present invention relates to an electrical current measurement arrangement for a varying inductive load, and to manufacturing of such an arrangement.

Background Art

Electrical current sensing is used in many applications, for instance when controlling electrical equipment such as electrical motors. By current sensing, operation difficulties and/or short-circuits may be detected and suitable preventive measures may thereby be taken.

There are two common methods used to sense the current. According to the first, the magnetic field produced by the current flowing in a conductor is detected and measured. This method however usually involves rather large components and may not be suitable for applications with space restrictions. According to the second method, a shunt resistance in the current path is utilized, across which a voltage is generated in proportion to the current flowing. In order to eliminate drawbacks related to soldering joints and/or difficulties with manufacturing of shunt resistors having small ohmic resistance, it may further be possible to allow part of the actual conductor through which the current is flowing to represent the shunt resistor.

During use, the resistance of the shunt resistor is bound to vary, as the temperature of the shunt resistor varies. Temperature variations may be the result of for instance varying ambient temperatures, and/or varying intrinsic heat generation of the shunt resistor caused by the current flowing there through. In order to provide careful current measurement results, it is necessary to compensate for these variations.

US 6,768,322, for instance, describes a device for measuring an electrical current that flows through a strip conductor, with a current-less measuring conductor extending in the current flow direction, along and in the proximity of a measuring section of the strip conductor. In order to detect the varying temperature, however, the measuring device requires a temperature sensor arranged near the strip conductor, which is connected to a control device of a power unit.

Additionally, US 6,768,322 claims to compensate for a manufacturing tolerance of the cross-section of the measuring section, i.e. to compensate for measuring errors which may occur due to varying width and thickness of the measuring path. However, in order for the measuring device to support this functionality, the proposed solution appears to require software steps of calibration during use of the device.

General disclosure of the Invention

It is therefore an object of the present invention to provide a solution according to which the above-related drawbacks are eliminated wholly or at least partly.

According to a first aspect of the invention, this may be achieved by an electrical current measurement arrangement for a varying inductive load. The arrangement comprises at least one shunt resistor having a shunt resistance at least partly influenced by an ambient temperature, through which shunt resistor a shunt current is adapted to flow and across which to measure a shunt voltage drop corresponding to said shunt current. The shunt resistor is represented by a plurality of conductive strips connected in parallel, each strip having a first predetermined width. The arrangement further comprises at least one compensation resistor having a compensation resistance similarly influenced by the ambient temperature, through which compensation resistor a predetermined compensation current is adapted to flow and across which to measure a compensation voltage drop corresponding to said compensation current. The compensation resistor is represented by a compensation conductor which has a second predetermined width. The shunt resistor and the compensation resistor are electrically separated, thermally connected, and derived from the same manufacturing process such that a compensation conductor thickness of the compensation conductor is equal to a strip thickness of the strips.

The invention likewise concerns a method for manufacturing such an electrical current measurement arrangement. Consequently, according to a second aspect of the invention, there is provided a method for manufacturing an electrical current measurement arrangement provided for a varying inductive load, which manufacturing method comprises providing at least one medium comprising an insulating layer and a metal structure arranged for physical support and heat dissipation of the arrangement. The manufacturing method further comprises arranging, on the medium, at least one shunt resistor having a shunt resistance at least partly influenced by an ambient temperature, through which shunt resistor a shunt current is adapted to flow and across which to measure a shunt voltage drop corresponding to the shunt current. The shunt resistor is arranged to be represented by a plurality of conductive strips connected in parallel, each strip having a first predetermined width. The manufacturing method furthermore comprises arranging, on the medium, at least one compensation resistor electrically separated from but thermally connected to the shunt resistor, which compensation resistor has a compensation resistance similarly influenced by the ambient temperature, through which compensation resistor a predetermined compensation current is adapted to flow and across which to measure a compensation voltage drop corresponding to the compensation current. The compensation resistor is arranged to be represented by a compensation conductor which has a second predetermined width. The shunt resistor and the compensation resistor are derived from the same manufacturing process, whereby a compensation conductor thickness of the compensation conductor is equal to a strip thickness of the strips.

It should be emphasized throughout the document that "equal to" should be interpreted in a broad sense, likewise including "nearly equal to" and "as close as possible to equal to".

When manufacturing and utilizing an electrical current measurement arrangement for assisting in steering an inductive load, the arrangement is bound to be exposed to a variety of circumstances affecting the reliability of the measuring process. The shunt resistor and subsequently the shunt resistance are influenced by the ambient temperature and likely intrinsic heat of the shunt resistor generated by the current flowing there through. Furthermore, as the resistance value of a resistor is reflected by its physical dimensions, i.e. cross section area along its length, the nominal value of the shunt resistance may deviate from an expected value due to manufacturing imperfection, i.e. manufacturing tolerances. With the electrical current measurement arrangement in accordance with the present invention, with an introduction of a compensation resistor as stated, these issues are however compensated for.

Since the shunt and compensation resistors are derived from the same manufacturing process, both resistors are subjected to similar circumstances during manufacturing. Such circumstances may for instance be the resistors being derived from the same material, whereby manufacturing tolerances affect the resistors in the same, or at least similar, way. In order to establish similar conditions for the compensation resistor as the shunt resistor, the compensation conductor is intended to have the same thickness as the shunt strips. The shunt strips resulting from the manufacturing process will as a result of manufacturing tolerances most likely have slightly defected cross section areas, i.e. each strip is likely to have an inconsistent thickness across its width along its length, for instance with edges being slightly curved rather than having right angles. In the same manner is the compensation conductor resulting from the manufacturing process expected to as a result of manufacturing tolerances have a slightly defected cross section area, i.e. an inconsistent thickness across its width along its length. With the shunt and compensation resistors having the same thickness derived from the same process, the type of potential defections to the thickness of the shunt strips and compensation conductor is identical or at least similar, whereby a deviation from the expected nominal compensation resistance value is identical or at least similar to a corresponding deviation of the shunt resistance value.

The compensation resistor is adapted such that the nominal compensation resistance is larger than the nominal shunt resistance, as the compensation current flowing through the compensation resistor is intended to be smaller than the shunt current flowing through the shunt resistor. Preferably, the relationship between the compensation resistor and the compensation current reflects the relationship of the shunt resistor and the shunt current, such that heat generated in the compensation resistor has a predetermined ratio to heat generated in the shunt resistor. Note that for some applications, the predetermined compensation current might need to be adapted to vary with the variations of the shunt current, such that the heat generation of the compensation resistor have a well-known relation to that of the shunt resistor. Due to the thermal conductivity between the shunt and compensation resistors, a temperature of the compensation resistor may be the same or at least similar to that of the shunt resistor, whereby the compensation resistor resistance is affected in the same manner as the shunt resistor resistance. That is, the resistors may be kept at the same temperature, or at least similar temperatures, such that a change in the shunt resistance value due to a change of ambient temperature or for instance increased intrinsic heat following increased shunt current, is reflected by the compensation resistance value of the compensation resistor.

Consequently, the compensation resistance value fluctuates in a manner corresponding to the fluctuation of the shunt resistance. The compensation resistor is hence utilized as a reference to improve the reliability of the measuring process, and a compensation reflecting circumstances affecting the compensation resistor may be utilized to compensate the shunt resistor accordingly. Should the same temperature for the resistors be troublesome to achieve, it might be necessary to take the previously discussed predetermined heat generation relation between the resistors into consideration for the compensation.

The compensation resistor may preferably be adapted to support smaller currents than those currents expected to flow through the shunt resistor, and the physical dimensions of the shunt and compensation resistors are thus designed accordingly. The width and/or length of the compensation conductor are chosen to suit the implementation in mind, and are not restricted to coincide with the width and a total extension length of the strips. The greater the length and/or width of the compensation conductor in comparison to the strips, the greater the relationship between the nominal shunt resistance and the nominal compensation resistance. According to preferred embodiments, a nominal compensation resistance value of the compensation resistor may be greater than a nominal shunt resistance value of the shunt resistor, preferably greater than 50 times the shunt resistance value, and most preferred greater than 100 times the shunt resistance value. However, it is likewise possible to choose the nominal value of the compensation resistance to be as much as 2000 times the nominal value of the shunt resistance, or even more, should that be desirable for the implementation in mind.

If suitable for the design, the second predetermined width may be equal to the first predetermined width, whereby each strip and the compensation conductor have essentially identical cross sections. Identical cross sections contribute to the manufacturing tolerances the compensation conductor is subjected to, to an even greater extent, coinciding with those of the strips.

It should be emphasized that "essentially identical" should be interpreted in a broad sense, likewise including "nearly identical" and "as close as possible to identical".

In order to in a convenient manner continuously compensate for the varying shunt resistance value, the electrical current measurement arrangement of the present invention preferably further comprises a control device adapted to continuously determine a correction factor between the compensation resistance and a corresponding nominal value based on the predetermined compensation current and the measured compensation voltage drop, thereby enabling for each measured value of the shunt voltage drop, and subsequently the shunt current, to be compensated with the correction factor. The frequency with which the control device updates the correction factor may be determined such that it suits the application in mind.

In a manner of efficiently supporting the electrical current measurement arrangement, the shunt resistor and the compensation resistor may be arranged on at least one medium comprising an insulating layer and a metal structure arranged for physical support and heat dissipation of the arrangement. According to a preferred embodiment, the shunt resistor and the compensation resistor are furthermore thermally connected to a carrier having higher thermal conductivity than FR-4, preferably metal. Thereby, a medium offering a physical platform and electrical insulation is provided along with efficient thermal conductivity supporting that the compensation resistor may contain the same temperature or at least a similar temperature as the shunt resistor.

Manufacturing of the resistors may for instance comprise the shunt resistor and the compensation resistor being derived from an etching process. Thereby, a feasible process of providing the shunt and compensation resistors known per se is utilized. According to one embodiment, the shunt resistor and the compensation resistor are represented by conductive traces, i.e. strips, from copper sheets. Using copper sheets to derive the resistors provides a well-known, robust and cost efficient solution.

For some embodiments of the electrical current measurement arrangement, a single compensation resistor is intended to be a reference for a plurality of shunt resistors. Consequently, the arrangement may comprise at least two shunt resistors and one compensation resistor. Such a disposition would represent an arrangement which in an efficient manner reuses one and the same compensation resistor, thereby providing for a cost effective solution.

By way of conclusion; by introducing an electrical current measurement arrangement as described in the foregoing for assisting in controlling an inductive load, the present invention thus eliminates the need for a temperature sensor, meanwhile compensates for manufacturing tolerances, as well as improves the reliability of the measuring process in an efficient manner.

Other aspects, benefits and advantageous features of the invention will be apparent from the following description and claims.

Brief Description of the Drawings

These and other aspects of the present invention will now be described in more detail with reference to the appended drawings showing currently preferred embodiments of the invention, wherein:

Figure 1A schematically illustrates a simplified exemplifying three-phase circuit feeding an inductive load, which circuit comprises an electrical current measurement arrangement in accordance with a first embodiment of the present invention.
Figure 1 B shows the exemplifying electrical current measurement arrangement of Figure 1A in greater detail.
Figure 2 schematically illustrates the shunt resistor and the corresponding compensation resistor in accordance with the first embodiment.
Figure 3 shows a cross section view of exemplifying layers of a medium on which the shunt resistor and compensation resistor of the first embodiment are arranged.
Figure 4 illustrates exemplifying steps for manufacturing of the electrical current measurement arrangement in accordance with the first embodiment.
Figure 5 illustrates exemplifying steps performed during use of the electrical current measurement arrangement in accordance with the first embodiment.

Detailed Description of the Preferred Embodiments of the Invention

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled addressee. Like reference characters refer to like elements throughout.

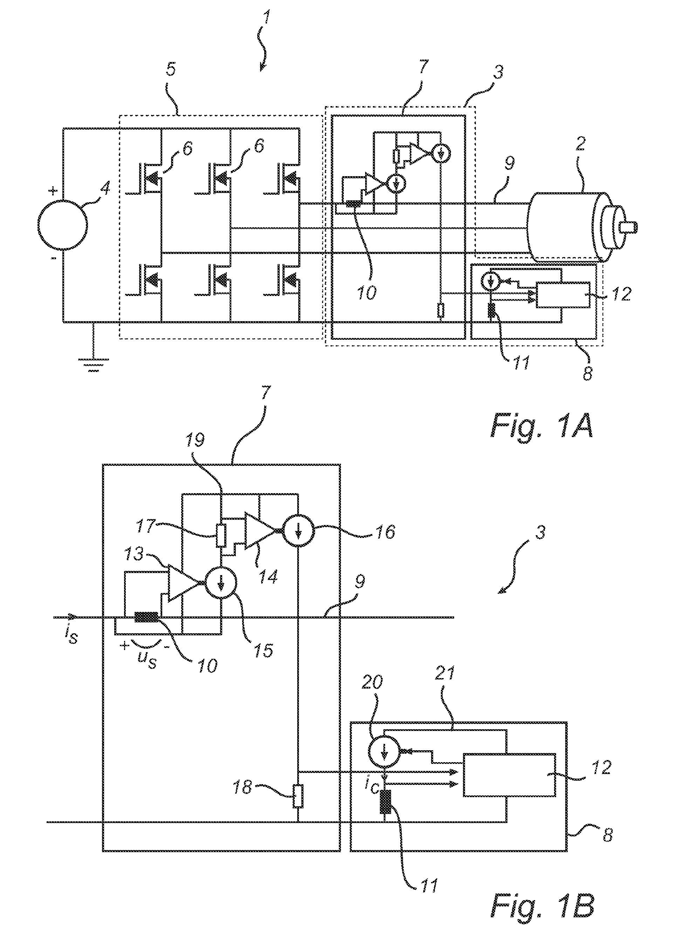

Figure 1 schematically illustrates a simplified exemplifying three-phase circuit 1 feeding an inductive load 2, which three-phase circuit 1 comprises an electrical current measurement arrangement 3 in accordance with a first embodiment of the present invention. The circuit 1 is here adapted for three-phase feeding and the inductive load 2 is a three-phase motor; however the invention is not restricted thereto. The inductive load 2 may represent any applicable electrical equipment, for instance a variety of electrical motors, and the circuit may naturally be adapted accordingly. In the illustrated example, a power supply 4 feeds the three-phase motor 2 via a three-phase bridge 5 comprising power transistors 6. Due to the exemplifying motor 2 being of three-phase type, six transistors 6 are provided. Should however the inductive load 2 be of another type, the number of power transistors 6 may naturally vary, for instance from one to five, and other components than power transistors applicable for the implementation may of course likewise be utilized.

Integrated in the three-phase circuit 1 are a shunt circuit 7 and a corresponding compensation circuit 8 which is electrically separated from the shunt circuit 7. Here, the circuits are connected to the same ground; this is however not necessary. The shown shunt and compensation circuits 7, 8 are simplified to comprise only exemplifying components representing the first embodiment. In Figure 1A, a single shunt circuit 7 is illustrated. However, a plurality of shunt circuits 7 may be implemented should that be preferred, for instance one for each phase of the motor 2. Furthermore, a single compensation circuit 8 is illustrated in the example. Note however, that although a single compensation circuit 8 may correspond to a plurality of shunt circuits 7, according to other embodiments, a separate compensation circuit 8 may be provided for each shunt circuit 7.

A conductor 9 extending from the three-phase bridge 5 to the inductive load 2 runs, in the illustration, through the shunt circuit 7. Along the inductive load conductor 9 is a shunt resistor 10 arranged, which shunt resistor 10 is integrated in the shunt circuit 7. Note however, that the shunt circuit 7 in other embodiments may be disposed differently, for instance in series with the power transistors 6.

The corresponding compensation circuit 8 comprises a compensation resistor 11 and a control device 12 such as a microprocessor. The control device 12 is preferred, but may be omitted in other embodiments. The shunt and compensation circuits 7, 8 will now be further described with reference to Figure 1 B.

Figure 1 B shows the exemplifying electrical current measurement arrangement 3 of Figure 1A in greater detail. The shunt circuit 7 of the illustrated example comprises, in addition to previously mentioned inductive load conductor 9 and shunt resistor 10, first and second amplifiers 13, 14, first and second voltage controlled current generators 15, 16, and first and second resistors 17, 18. Reference 19 denotes a first power supply feeding the shunt circuit 7; typically although not necessarily in the range 10-20 V. The first amplifier 13 is arranged to amplify a shunt voltage $u_S$ across the shunt resistor 10 and the first voltage controlled current generator 15 to mirror up a signal, taken from the first resistor 17, to the first power supply 19. The second amplifier 14 and the second voltage controlled current generator 16 are arranged to mirror down the signal to ground. The effect will thus be that the signal from the inductive load conductor 9, which is bound to bounce up and down, will be transformed to a steady ground potential. With the presented disposition, currents through the first as well as the second voltage controlled current generator 15, 16 will be proportional to a shunt current is through the inductive load conductor 9. The second resistor 18 is arranged to convert current through the second voltage controlled current generator 16 to a voltage.

The compensation circuit 8 of the illustrated example comprises, in addition to previously mentioned compensation resistor 11 and control device 12, a third voltage controlled current generator 20. Reference 21 denotes a second power supply feeding the compensation circuit 8; typically although not necessarily in the range 3-5 V. The third voltage controlled current generator 20 is arranged to feed the compensation resistor 11 with a predetermined current $i_C$. The predetermined current $i_C$ is not restricted to a fixed value, and may thus continuously be selected to properly suit the shunt current is.

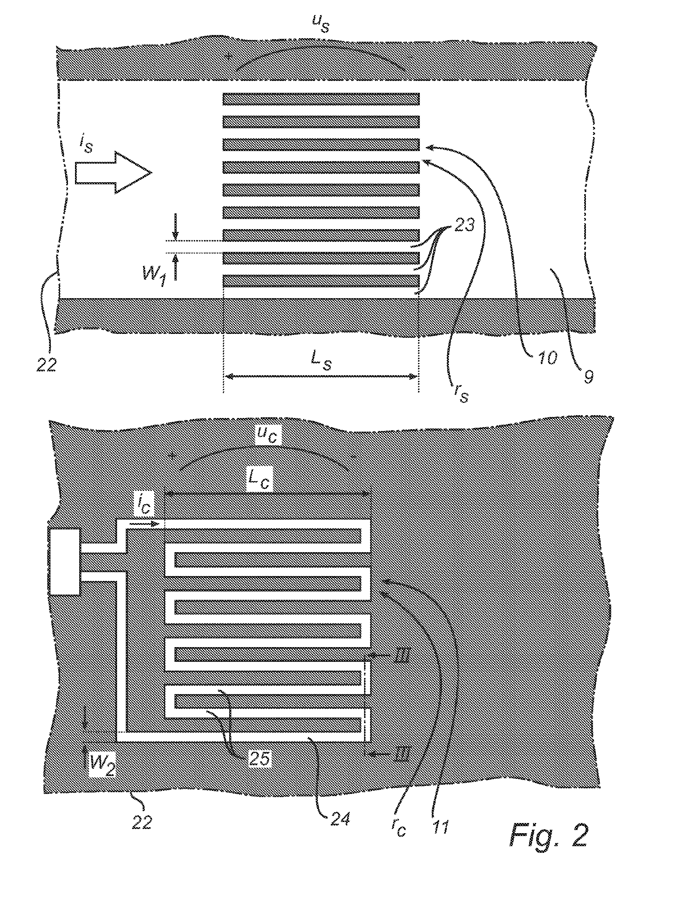

It should one again be emphasized that with exception from the shunt and compensation resistors 10, 11, the components 12-21 of the shunt and compensation circuits 7, 8 and the manner in which they are disposed in the illustration, are exemplifying. Additional and/or other components which may support the shunt and compensation resistors 10, 11 in a similar manner in accordance with the present invention, are likewise feasible. The shunt and compensation resistors 10, 11, which are essential to the present invention, will now be described in further detail with reference to Figure 2.

Figure 2 schematically illustrates the shunt resistor 10 and the corresponding compensation resistor 11 in accordance with the first embodiment. Note that the resistors 10, 11 are disposed in a manner which simplifies the description, and hence do not reflect the actual position of the resistors 10, 11 in relation to each other. Although not shown, in reality they are thermally connected, but electrically separated.

In Figure 2, a part of the inductive load conductor 9 is shown, provided on a medium 22. Arranged along the conductor 9 is the shunt resistor 10, through which the shunt current is is arranged to flow, and across which the shunt voltage drop $u_S$ corresponding to the shunt current is may be retrieved. Reference $r_S$ denotes the ohmic shunt resistance of the shunt resistor 10, which nominal value $r_{S,nominal}$ is reflected by the physical dimensions of the shunt resistor 10. The shunt resistor 10 is represented by a plurality of conductive strips 23 connected in parallel. According to this first embodiment, there are ten strips 23 provided. The present invention is however not restricted thereto; any number of strips 23 suitable for a specific implementation is naturally covered by the scope. Each strip 23 has here a length $L_S$ and a first predetermined width $W_1$.

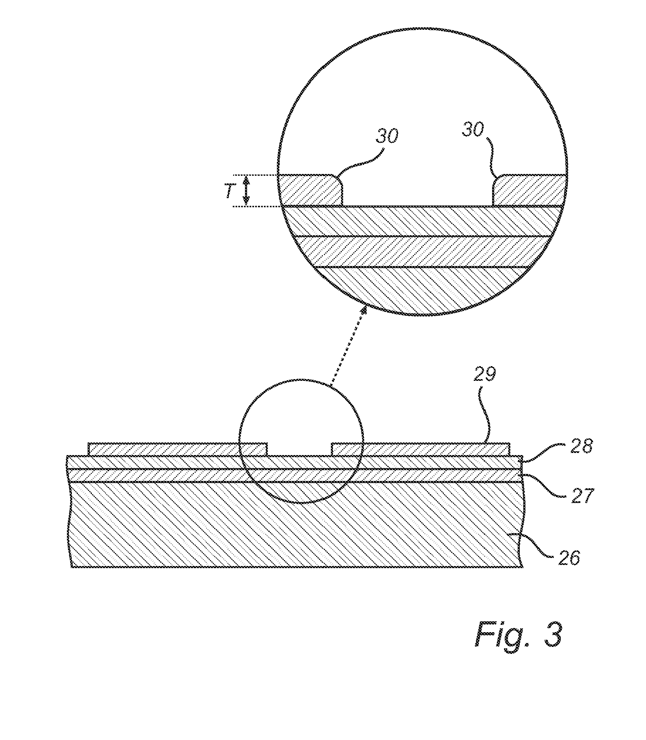

Likewise arranged on the medium 22 is the compensation resistor 11, through which the compensation current $i_C$ is arranged to flow, and across which a compensation voltage $u_C$ corresponding to the compensation current $i_C$ may be retrieved. Reference $r_C$ denotes the ohmic compensation resistance of the compensation resistor 11, which nominal value $r_{C,nominal}$ is reflected by the physical dimensions of the compensation resistor 11. The compensation resistor 11 is represented by a compensation conductor 24 arranged in parallel conductive tracks 25 connected in series. According to this first embodiment, there are ten tracks 25 provided, each here having a length $L_C$ which is approximately the same as the length $L_S$ of the shunt resistor strips 23. Note however that for other embodiments, neither lengths nor the number of tracks 25 need to coincide with those of the strips 23. The number of tracks 25 and their lengths $L_C$, which lengths naturally not need to be the same for the different tracks 25, may be determined as preferred by the designer, depending on for instance space available on the medium 22, and will be further discussed in conjunction with Figure 3.

The compensation conductor 24 has a second predetermined width $W_2$. In the illustration, this second width $W_2$ of the compensation conductor 24 is equal to the width $W_1$ of the shunt resistor strips 23. However, if preferred by the designer, width $W_2$ may differ from width $W_1$.

Figure 3 illustrates layers of the medium 22, on which the shunt resistor 10 and compensation resistor 11 are arranged. Shown is a cross section view of the medium 22 derived from Figure 2, comprising a part of the compensation resistor 11. Note that for the sake of simplicity, only a cross section view of the compensation resistor 11 and not the shunt resistor 10 is shown; however the layers of the shunt resistor 10 are intended to be identical to those of the compensation resistor 11. It should furthermore be emphasized that additional layers and/or components other than those described hereinafter may be comprised in or on the medium 22.

Starting from the bottom layer, a metal structure, i.e. a cooling layer 26, is provided preferably for physical support as well as for supporting heat dissipation. The cooling layer 26 may be of aluminium, and may furthermore be for instance a heat sink, or a cooling fin. Preferably, and as shown in Figure 3, on top of the cooling layer 26 is a carrier 27 arranged. The carrier 27 may be a metal base comprising for instance aluminium or copper such that good thermal conductivity is provided. Preferably, although not necessarily, the carrier 27 has higher thermal conductivity than FR-4 commonly known in the art. An approximate thickness of this layer may be 1.5 mm. Next, an insulating layer 28 may be arranged, providing electrical isolation as well as contributing to desired thermal conductivity. The insulating layer 28 may for instance comprise a polymer with metal oxide, or an aluminium oxide on top of which a thin insulating coating is provided. Alternatively, the insulating layer 28 may comprise ceramic. Note that the invention is not restricted to the layers here presented. For other embodiments, commonly known glass fibre PCBs (printed circuit boards) may also be utilized.

Finally, on top of the layers 26-28, the shunt and compensation resistors 10, 11 are arranged. Here is as previously mentioned only a part of the compensation resistor 11 shown, intended to represent as well the shunt resistor 10. In the illustrated example, the resistors 10, 11 are represented by copper traces, i.e. conductive strips, which are derived from a copper layer 29. The layer may be for instance 30 to 140 $\mu$m. Other metals may naturally be used should that be preferred, such as for instance foils comprising silver.

The shunt and compensation resistors 10, 11 are preferably thermally connected to each other via the carrier 27, such that heat will be dissipated from the resistors 10, 11 under the same efficient conditions. Alternatively, if the medium 22 comprises for instance a PCB having poorer thermal conductivity characteristics than a medium 22 comprising a metal base carrier 27, the current $i_C$ through the compensation resistor 11 would need to be adapted to be proportional to the shunt current is, and would thus need to be varied as the shunt current is varies. With either of the mentioned solutions, the arrangement 3 is consequently adapted to dissipate heat from the resistors 10, 11 such that the compensation resistor 11 continuously holds a temperature equal to or at least similar to that of the shunt resistor 10.

A compensation resistor thickness T of the copper traces forming the compensation conductor 24 is identical, or as close to identical as possible, to a strip thickness T of the copper traces forming the shunt strips 23. Defections to a constant thickness T across the widths $W_1$, $W_2$ and along the strips 23 and compensation conductor 24 are in Figure 3 illustrated as curves 30 rather than right angles at the edges along the compensation conductor 11.

The compensation conductor 24 of the first embodiment consequently has the thickness T, defections 30 and width $W_2$, and subsequently the same or close to the same cross section as the shunt strips 23. Since the length $L_C$ of the respective tracks 25 here is the same as the length $L_S$ of the shunt strips 23, and the strips 23 are connected in parallel meanwhile the tracks 25 here are connected in series, the length of the compensation conductor 24 is approximately ten times the length of a shunt strip 23. Subsequently, the nominal compensation resistance value $r_{C,nominal}$ is 100 times the nominal shunt resistance value $r_{S,nominal}$. With this configuration, the compensation resistor 11 is dimensioned to support much smaller currents $i_C$ than those currents is expected to flow through the shunt resistor 10. Although a solution for the compensation resistor 11 here is represented by tracks 25 connected in series to form the compensation conductor 24, the invention is not restricted thereto. Other dispositions of e.g. copper traces forming the compensation resistor 11 with a nominal compensation resistance $r_{C,nominal}$ appropriate for the implementation in mind is naturally covered by the scope. It should further be emphasized that the length of the compensation conductor 24, and subsequently the nominal compensation resistance $r_{C,nominal}$, by no means is restricted to coincide with the total extension length of the strips 23. Choosing an even greater length of the compensation conductor 24, for instance by providing a hundred instead of ten conductive tracks 25 each of length $L_C$ in series, the nominal compensation resistance $r_{C,nominal}$ will be as much as 1000 times the nominal shunt resistance $r_{S,nominal}$. Alternatively to increasing the length of the compensation conductor 24, the compensation resistor 11 may be given a greater compensation resistance $r_C$ by designing the compensation conductor 24 to have a greater width $W_2$. Preferably, a resistance relation between the shunt and compensation resistors 10, 11 ranges from 100 to 2000; however, other ratios are naturally also covered by the scope. It should once again be emphasized that the thickness T should never be designed to vary; the thickness T of the compensation conductor 24 is always intended to be equal to the thickness T of the strips 23.

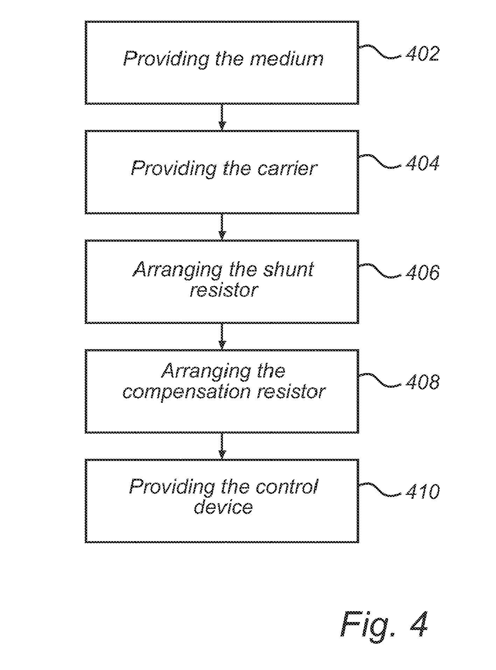

In order to provide the same, or close to the same, thickness T of the compensation conductor 24 and the shunt strips 23, the shunt and compensation resistors 10, 11 are derived from the same manufacturing process as is described in conjunction with Figure 4. Deriving both resistors 10, 11 from the same manufacturing process implies that the resistors 10, 11 are subjected to similar circumstances, such that manufacturing tolerances affect the resistors 10, 11 in the same way.

Figure 4 illustrates exemplifying steps for manufacturing of the electrical current measurement arrangement 3 in accordance with the first embodiment. It should be noted that the following steps may be performed in other orders than suggested, and even simultaneously

In steps 402 and 404, respectively, the medium 22 and the optional carrier 27 are provided. The carrier 27 is preferably further provided with the insulating layer 28. In steps 406 and 408, respectively, the shunt and compensation resistors 10, 11 are arranged on the medium 22. Arranging the resistors 10, 11 may for instance comprise etching the resistors 10, 11 out of copper layers 29. Conductive copper traces, i.e. the resistors 10, 11 along with the rest of the conductive pattern, are thereby derived from the copper layer 29 in a manner known per se. Different patterning methods may be applied, both subtractive methods such as for instance silk screen printing, photoengraving and PCB milling that remove the e.g. copper, and additive processes; all known in the art. For instance, in alternative embodiments, the copper traces 23, 24 may be printed onto the medium 22, which may be preferred if the medium 22 comprises ceramic. Furthermore, additional copper may in a subsequent step be added in a galvanic process.

Regardless of manufacturing process utilized, the resulting e.g. copper traces 23, 24 ideally have rectangular cross sections, i.e. the thickness T is constant across and along the shunt strips 23 and compensation conductor 24. However, due to manufacturing tolerances in the e.g. etching process, edges 30 of the resulting copper traces 23, 24 are bound to as shown in Figure 3 rather than right angles to some extent be slightly defected, such as curved. It should be emphasized that the cross section of the compensation conductor 24 in accordance with the shown embodiment due to being subjected to the same manufacturing process will have identical, or at least similar, defects 30 as the cross sections of strips 23. That is, the thickness T along the width $W_2$ of the compensation conductor 24 will exhibit the same curved edges 30 as the thickness T along the width $W_1$ of the strips 23. Designing the compensation conductor 24 and the strips 23 to have identical widths, i.e. $W_2$ equal to $W_1$, implies that the respective cross section areas, which are then identical, are in particular affected in a similar manner by the manufacturing tolerances.

In step 410, the optional control device 12 is provided to the electrical current measurement arrangement 3.

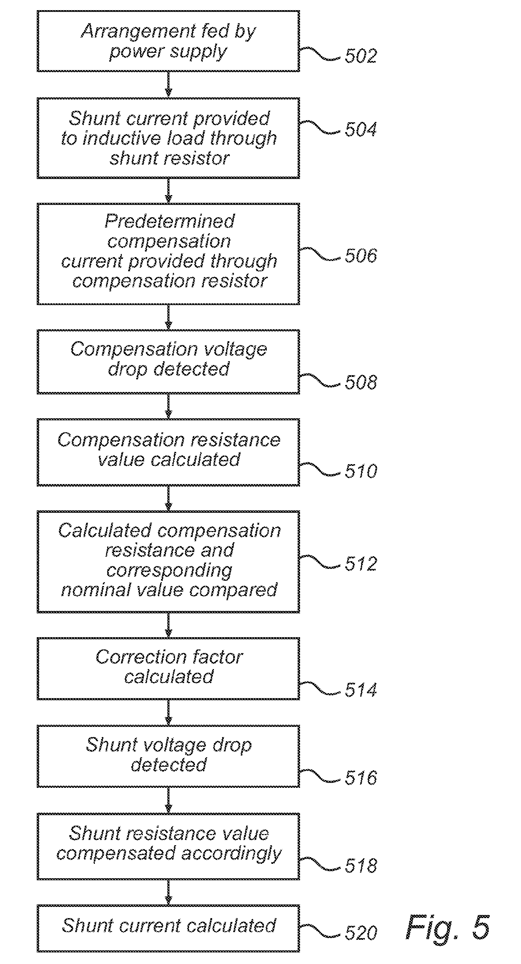

In use, the benefits of the features of the shunt and compensation resistors 10, 11 are apparent, and a measuring procedure will now be described in conjunction with Figure 5.

Figure 5 illustrates exemplifying steps performed during use of the electrical current measurement arrangement 3 in accordance with the first embodiment. It should be noted that the following steps may be performed in other orders than suggested, and even simultaneously. Furthermore, the measuring process described is an ongoing process, why the steps described hereinafter are performed continuously and/or repeatedly.

When manufacturing and utilizing the electrical current measurement arrangement 3 for assisting in steering electrical equipment 2, the arrangement 3 is bound to be exposed to a variety of circumstances affecting the reliability of the measuring process. The shunt resistor 10 and subsequently the shunt resistance $r_S$ is influenced by intrinsic heat generated in the resistor 10 resulting from the shunt current is flowing through the strips 23. Additionally, the shunt resistance $r_S$ is influenced by the ambient temperature. Furthermore, the nominal shunt resistance $r_{S,nominal}$ may as previously stated deviate from an expected value due to variations in the manufacturing process, i.e. manufacturing tolerances. With the electrical current measurement arrangement 3 in accordance with the first embodiment, manufactured as implied in Figure 4, these issues are compensated for. The compensation resistance value $r_C$ fluctuates in a manner corresponding to the fluctuation of the shunt resistance $r_S$. The compensation resistor 11 may hence be utilized as a reference to improve the reliability of the measuring process, and a compensation reflecting circumstances affecting the compensation resistor 11 may be utilized to compensate the shunt resistor 10 accordingly, as will be described hereunder.

In step 502, the inductive load 2, and hence the electrical current measurement arrangement 3, is fed by the power supply 4. Subsequently, the shunt current is is, in step 504, provided through the shunt resistor 10. The predetermined current $i_C$ which is determined based on the dimensions selected for the compensation resistor 11 and other components of the design, is in step 506 provided through the compensation resistor 11.

In step 508, the voltage drop $u_C$ across the compensation resistor 11 is detected. Thereby, since the nominal compensation resistance $r_{C,nominal}$ and the current $i_C$ through the compensation resistor 11 are known, in that

$$U_{C,nominal} = R_{c,nominal} * i_C, \qquad \text{(Equation 1)}$$

where $U_{C,nominal}$ is a voltage drop value across the compensation resistor 11 for the nominal resistance value $R_{C,nominal}$, the compensation resistance $r_C$ may be calculated in step 510, by

$$r_C = R_{c,nominal} * u_C / U_{C,nominal}. \qquad \text{(Equation 2)}$$

The compensation resistance $r_C$ and the corresponding nominal value $R_{C,nominal}$ are in step 512 compared, and in step 514, a correction factor k is calculated by

$$k = R_{C,nominal} */ r_{c.} \qquad \text{(Equation 3)}$$

In step 516, the shunt voltage drop $u_S$ across the shunt resistor 10 is detected. In step 518, since the nominal value of the shunt resistance $r_{S,nominal}$ is known, the compensated shunt resistance $r_S$ value may be calculated utilizing the correction factor k, by

$$r_S = R_{S,nominal} / k. \qquad \text{(Equation 4)}$$

Finally, in step 420, the shunt current $i_C$ through the shunt resistor $r_S$ may be calculated, by

$$i_S = u_S / r_S. \qquad \text{(Equation 5)}$$

Note that the given equations not necessarily need to be followed as stated; other computations resulting in an equivalent compensating correction factor k are likewise covered by the scope.

The nominal values $R_{S,nominal}$ and $R_{C,nominal}$ are in the exemplifying first embodiment pre-stored in the control device 12. The control device 12 furthermore continuously retrieves the detected voltages $u_C$, $u_S$, and performs the necessary computations of the above stated equations 1-5.

The present inventive concept has been described above by way of example, and the person skilled in the art realizes that the present invention by no means is limited to the preferred embodiments described above.

It should furthermore be obvious that the devices, elements etc. illustrated in the drawings, are not drawn according to scale.

**Claims**

**1.** An electrical current measurement arrangement (3) for a varying inductive load (2), which arrangement (3) comprises:

at least one shunt resistor (10) having a shunt resistance ($r_S$) at least partly influenced by an ambient temperature, through which shunt resistor (10) a shunt current (is) is adapted to flow (504) and across which to measure (516) a shunt voltage drop ($u_S$) corresponding to said shunt current (is), said shunt resistor (10) being represented by a plurality of conductive strips (23) connected in parallel, each strip (23) having a first predetermined width ($W_1$); and

at least one compensation resistor (11) having a compensation resistance ($r_C$) similarly influenced by said ambient temperature, through which compensation resistor (11) a predetermined compensation current ($i_C$) is adapted to flow (506) and across which to measure (508) a compensation voltage drop ($u_C$) corresponding to said compensation current ($i_C$), said compensation resistor ($r_C$) being represented by a compensation conductor (24) having a second predetermined width ($W_2$);

wherein said shunt resistor (10) and said compensation resistor (11) are electrically separated, thermally connected, and derived from the same manufacturing process such that a compensation conductor thickness (T) of said compensation conductor (24) is equal to a strip thickness (T) of said strips (23).

2. The electrical current measurement arrangement (3) according to claim 1, wherein said second predetermined width ($W_2$) is equal to said first predetermined width ($W_1$), whereby each strip (23) and said compensation conductor (24) have essentially identical cross sections.

3. The Electrical current measurement arrangement (3) according to any one of claim 1 or 2, further comprising:

a control device (12) adapted to continuously determine (512, 514) a correction factor (k) between the compensation resistance ($r_C$) and a corresponding nominal value ($R_{C,nomnal}$) based on the predetermined compensation current ($i_C$) and the measured compensation voltage drop ($u_C$), thereby enabling for each measured value of said shunt voltage drop ($u_C$), and subsequently said shunt current ($i_C$), to be compensated (516, 518) with said correction factor (k).

4. The electrical current measurement arrangement (3) according to any one of the preceding claims, wherein said shunt resistor (10) and said compensation resistor (11) are arranged on at least one medium (22) comprising an insulating layer (28) and a metal structure (26) arranged for physical support and heat dissipation of said arrangement (3).

5. The electrical current measurement arrangement (3) according to claim 4, wherein said shunt resistor (10) and said compensation resistor (11) are thermally connected to a carrier (27) having higher thermal conductivity than FR-4.

6. The electrical current measurement arrangement (3) according to claim 5, wherein said carrier (27) comprises a metal.

7. The electrical current measurement arrangement (3) according to any one of the preceding claims, wherein said shunt resistor (10) and said compensation resistor (11) are derived from an etching process.

8. The electrical current measurement arrangement (3) according to any one of claims 5 to 7, wherein said shunt resistor (10) and said compensation resistor (11) are represented by conductive traces (23, 24) from copper sheets (29).

9. The electrical current measurement arrangement (3) according to any one of the preceding claims, wherein a nominal compensation resistance value ($R_{C,nominal}$) of said compensation resistor (11) is greater than a nominal shunt resistance value ($R_{S,nominal}$) of said shunt resistor (10), preferably greater than 50 times said shunt resistance value ($R_{C,nominal}$), and most preferred greater than 100 times said shunt resistance value ($R_{C,nominal}$).

10. The electrical current measurement arrangement (3) according to any one of the preceding claims, wherein said arrangement (3) comprises at least two shunt resistors (10) and one compensation resistor (11).

11. A method for manufacturing an electrical current measurement arrangement (3) provided for a varying inductive load (2), which manufacturing method comprises the steps of:

providing (402) at least one medium (22) comprising an insulating layer (28) and a metal structure (26) arranged for physical support and heat dissipation of said arrangement (3);
arranging (406), on said medium (22), at least one shunt resistor (10) having a shunt resistance ($r_S$) at least partly influenced by an ambient temperature, through which shunt resistor (10) a shunt current (is) is adapted to flow (504) and across which to measure (516) a shunt voltage drop ($u_S$) corresponding to said shunt current (is), said shunt resistor (10) being arranged as represented by a plurality of conductive strips (23) connected in parallel, each strip (23) having a first predetermined width ($W_1$); and

arranging (408), on said medium (22), at least one compensation resistor (11) electrically separated from but thermally connected to said shunt resistor (10), said compensation resistor (11) having a compensation resistance ($r_C$) similarly influenced by said ambient temperature, through which compensation resistor (11) a predetermined compensation current ($i_C$) is adapted to flow (506) and across which to measure (508) a compensation voltage drop ($u_C$) corresponding to said compensation current ($i_C$), said compensation resistor (11) being arranged as represented by a compensation conductor (24) having a second predetermined width ($W_2$);

wherein said shunt resistor (10) and said compensation resistor (11) are derived from the same manufacturing process, whereby a compensation conductor thickness (T) of said compensation conductor (24) is equal to a strip thickness (T) of said strips (23).

**12.** The method according to claim 11, further comprising the step of:

adapting said second predetermined width ($W_2$) to be equal to said first predetermined width ($W_1$), whereby each strip (23) and said compensation conductor (24) have essentially identical cross sections.

**13.** The method according to any one of claim 11 or 12, further comprising the step of:

providing (410) a control device (12) adapted to continuously determine (512, 514) a correction factor (k) between the compensation resistance ($r_C$) and a corresponding nominal value ($r_{C,nominal}$) based on the predetermined compensation current ($i_C$) and the measured compensation voltage drop ($u_C$), thereby enabling for each measured value of said shunt voltage drop ($u_C$), and subsequently said shunt current ($i_C$), to be compensated (518, 520) with said correction factor.

**14.** The method according to any one of claims 11 to 13, further comprising the step of:

providing (404) a carrier (27) having higher thermal conductivity than FR-4, to which carrier (27) said shunt resistor (10) and said compensation resistor (11) are thermally connected.

**15.** The method according to any one of claims 11 to 14, further comprising the step of:

etching said shunt resistor (10) and said compensation resistor (11).

*Fig. 1A*

*Fig. 1B*

Fig. 2

*Fig. 3*

Providing the medium — 402

Providing the carrier — 404

Arranging the shunt resistor — 406

Arranging the compensation resistor — 408

Providing the control device — 410

*Fig. 4*

```
┌─────────────────────────┐
│   Arrangement fed by    │ ～ 502
│     power supply        │
└─────────────────────────┘
            │
            ▼
┌─────────────────────────┐
│  Shunt current provided │ ～ 504
│  to inductive load through │
│      shunt resistor     │
└─────────────────────────┘
            │
            ▼
┌─────────────────────────┐
│    Predetermined        │
│    compensation         │ ～ 506
│  current provided through │
│   compensation resistor │
└─────────────────────────┘
            │
            ▼
┌─────────────────────────┐
│  Compensation voltage   │ ～ 508
│     drop detected       │
└─────────────────────────┘
            │
            ▼
┌─────────────────────────┐
│  Compensation resistance │ ～ 510
│    value calculated     │
└─────────────────────────┘
            │
            ▼
┌─────────────────────────┐
│ Calculated compensation │
│    resistance and       │ ～ 512
│    corresponding        │
│  nominal value compared │
└─────────────────────────┘
            │
            ▼
┌─────────────────────────┐
│   Correction factor     │ ～ 514
│     calculated          │
└─────────────────────────┘
            │
            ▼
┌─────────────────────────┐
│   Shunt voltage drop    │ ～ 516
│      detected           │
└─────────────────────────┘
            │
            ▼
┌─────────────────────────┐
│  Shunt resistance value │ ～ 518
│  compensated accordingly │
└─────────────────────────┘
            │
            ▼
┌─────────────────────────┐
│ Shunt current calculated │ ～ 520
└─────────────────────────┘
```

*Fig. 5*

15

Europäisches
Patentamt
European
Patent Office
Office européen
des brevets

**EUROPEAN SEARCH REPORT**

Application Number

EP 08 16 5094

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2005 051848 A1 (INFINEON TECHNOLOGIES AG [DE]) 3 May 2007 (2007-05-03) * abstract; claims 1-8,13; figures * * paragraphs [0004], [0009], [0016] * * paragraph [0021] - paragraph [0025] * | 1-15 | INV. G01R19/32 G01R1/20 |
| X | US 6 313 977 B1 (HAUER GERALD [DE]) 6 November 2001 (2001-11-06) * abstract; claims 1,4; figures * * column 2, line 10 - line 39 * * column 3, line 25 - line 36 * * column 4, line 4 - line 12 * * column 4, line 33 - line 36 * | 1-15 | |
| X | EP 1 452 879 A (SANKEN ELECTRIC CO LTD [JP]) 1 September 2004 (2004-09-01) * abstract; figures 1-3 * * paragraph [0089] * | 1,11 | |
| X | US 2007/103174 A1 (TANAKA HIRONORI [JP]) 10 May 2007 (2007-05-10) * abstract; figure 2 * * paragraph [0032] * | 1,11 | TECHNICAL FIELDS SEARCHED (IPC) G01R F16H H01C |
| A | WO 99/67653 A (SENTEC LTD [GB]; DAMES ANDREW NICHOLAS [GB]) 29 December 1999 (1999-12-29) * the whole document * | 1-15 | |
| A | US 2004/196056 A1 (KRONROD JAMES M [US]) 7 October 2004 (2004-10-07) * the whole document * | 1-15 | |
| A | DE 25 01 824 A1 (KRASNOD SAWOD ELEKTROISMERITEL) 22 July 1976 (1976-07-22) * the whole document * | 1-15 | |

The present search report has been drawn up for all claims

| Place of search | Date of completion of the search | Examiner |
|---|---|---|
| Berlin | 5 March 2009 | Fritz, Stephan C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 16 5094

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2009

| Patent document cited in search report | Publication date | Patent family member(s) | Publication date |
|---|---|---|---|
| DE 102005051848 A1 | 03-05-2007 | US 2007115009 A1 | 24-05-2007 |
| US 6313977 B1 | 06-11-2001 | NONE | |
| EP 1452879 A | 01-09-2004 | WO 03048790 A1<br>JP 4124125 B2<br>JP 2008216262 A<br>US 2005002143 A1 | 12-06-2003<br>23-07-2008<br>18-09-2008<br>06-01-2005 |
| US 2007103174 A1 | 10-05-2007 | CN 1947025 A<br>DE 112005000986 T5<br>JP 2005315729 A<br>WO 2005106513 A1<br>KR 20070013314 A | 11-04-2007<br>29-03-2007<br>10-11-2005<br>10-11-2005<br>30-01-2007 |
| WO 9967653 A | 29-12-1999 | AU 4630399 A<br>DE 69905044 D1<br>DE 69905044 T2<br>EP 1092159 A1<br>US 2002024334 A1 | 10-01-2000<br>27-02-2003<br>25-09-2003<br>18-04-2001<br>28-02-2002 |
| US 2004196056 A1 | 07-10-2004 | NONE | |
| DE 2501824 A1 | 22-07-1976 | NONE | |

EPO FORM P0459

For more details about this annex : see Official Journal of the European Patent Office, No. 12/82

**EP 2 169 412 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6768322 B